# EUROPEAN PATENT APPLICATION

(11) **EP 1 507 439 A2**
(43) Date of publication of application: **16.02.2005**
(21) Application number: 04015693.7
(22) Date of filing: 03.07.2004
(51) Int. Cl.: H04R 5/04

(54) **Apparatus and method for controlling speakers**

(30) Priority: 22.07.2003 KR 2003050267; 16.03.2004 US 801421
(71) Applicant: Samsung Electronics Co., Ltd., Suwon-si, Gyeonggi-do (KR)
(72) Inventor: Kim, Jong-Ho, Seoul (KR); Hong, Keun-cheol, dong Yeontong-gu Suwon-si Gyeonggi-do (KR); Rha, Hae-Young, Seoul (KR); Joe, Kee-won, Yongin-si Gyeonggi-do (KR); Shin, Jong-chul, Suwon-si Gyeonggi-do (KR)
(74) Representative: Patentanwälte Ruff, Wilhelm, Beier, Dauster & Partner

(57) **Abstract**

An apparatus and method are provided for controlling a plurality of speakers, comprising an amplifier for amplifying and outputting a play signal to be played over the speakers; and at least one sensor disposed proximal to at least one of the speakers for sensing at least one environmental condition and outputting sensing data to a controller, wherein the controller adjusts the play signal to compensate for environmental changes based on the sensing data.

## Description

The invention relates to an apparatus and a method for controlling a plurality of speakers.

In entertainment facilities such as movie houses, sound studios, and concert halls, high quality audio and/or visual playback equipment is used to playback the audio or visual program to the audience. With advances in television technology and increased availability of large screen high definition televisions for use in homes, home theatre audio equipment have also increased in demand.

High quality audio reproduction or playback equipment includes a receiver for receiving audio signals from a device such as a DVD player which reads audio and visual information from an audio visual medium such as a DVD disc. The playback medium outputs the signals playback from the audio visual program to an amplifier for amplification and the amplified signals are output to speakers for audio playback. To faithfully reproduce recorded music or surround sound, speakers are strategically placed to reproduce different aspects of the sound track. For example in a home theatre audio playback system, speakers are designed differently if they are intended to be used as center speakers, side speakers or used as subwoofers. The center speaker is usually placed at front center of the viewing or listening area and side speakers are placed on the sides of the listening audience. If a speaker is disposed far from a location optimized for playback, the time of travel of the signal to be played over that speaker will result in audio playback that is sub-optimal. Environmental conditions such as temperature and humidity also affect speed of travel of audio signals. Thus, speakers placed in locations different from locations designed to be optimal will result in playback of an audio program. Also, even with speakers placed in locations designed for optimal audio playback, changes in environmental conditions such as temperature and humidity can also cause audio signals to arrive at times different from optimal, again causing suboptimal playback.

It is the technical problem underlying the invention to provide for an apparatus and a method for controlling a plurality of speakers, which apparatus and method are capable of avoiding at least partly the difficulties found in the conventional apparatus and methods as discussed above.

The invention solves this problem by providing an apparatus having the features of claim 1 or 5, and a method having the features of claim 15. Further embodiments of the invention are given in the subclaims the wording of which is incorporated by reference into the present specification.

An apparatus for controlling a plurality of speakers according to the invention comprises an amplifier for amplifying and outputting a play signal to be played over the speakers; and at least one sensor disposed proximal to at least one of the speakers for sensing at least one environmental condition and outputting sensing data to a controller, wherein the controller adjusts the play signal to compensate for environmental changes based on the sensing data. The environmental conditions can be one of temperature and humidity.

The apparatus may further include a detector disposed in each of the speakers configured for receiving a test signal originating from the controller and for reporting to the controller the test signal received at respective speakers, wherein the controller determines the relative positions of the speakers based on the test signals reported by the speakers.

The controller may generate compensation data for adjusting the play signal for respective speakers based on the relative positions of the speakers.

The apparatus may further include a memory for storing the compensation data.

The memory may further store sensing data read at the time of determination of the relative positions of the speakers. The memory is e.g. one of a register, an SRAM, a DRAM, and a flash memory.

The detector may be an ultrasonic detector. Alternatively, the detector is a speaker used as a microphone. The relative position may be determined based on the test signal received at a first one of the speakers and played by the first speaker and the played test signal is received by the other speakers.

According to an embodiment of the invention, a respective sensor is disposed in each of the speakers. According to another embodiment, the sensor is disposed in the controller.

A method of controlling a plurality of speakers according to the invention comprises outputting from an amplifier a play signal to be played over the speakers; sensing by a sensor at least one environmental condition at a position proximal to at least one of the speakers and outputting sensing data to a controller; and adjusting the play signal to compensate for environmental changes based on the sensing data.

The sensor may sense at least one of temperature and humidity.

The method may further include determining relative positions of the speakers by receiving at each speaker a test signal originating from the controller; reporting to the controller the test signal received at respective speakers; and calculating relative positions of the speakers based on the test signals reported by the speakers.

The method may further include generating compensation data for adjusting the play signal for respective speakers based on the relative positions of the speakers.

The method may further include storing in a memory the compensation data.

The method may further include storing sensing data read at the time of determination of the relative positions of the speakers.

The memory may be one of a register, an SRAM, a DRAM, and a flash memory.

The step of receiving may be performed by an ultrasonic detector or by a speaker used as a microphone or by a microphone.

The relative position may be determined based on the test signal received at a first one of the speakers and played by the first speaker and the played test signal is received by the other speakers.

A respective sensor may be disposed in each of the speakers, or the sensor may be disposed in the controller.

The sensor may sense temperature and/or humidity.

According to another embodiment of the invention, an apparatus is provided for controlling a plurality of speakers, comprising an amplifier for outputting an amplified play signal to be played over the speakers, a controller for originating a test signal for receipt by the plurality of speakers and for receiving return signals from each speaker, the return signals representing the test signals as received at each respective speaker, said controller for determining relative positions of the speakers based on the return signals and for generating compensation data based on the relative positions of the speakers, wherein the compensation data is used for adjusting the play signal.

The apparatus may further include a detector disposed in each speaker for receiving the test signal. The detector may be an ultrasonic detector. Alternatively, the detector is a speaker used as a microphone.

The apparatus may further include at least one sensor disposed proximal to at least one of the speakers for sensing at least one environmental condition and outputting sensing data to the controller, wherein the controller adjusts the play signal to compensate for environmental changes based on the sensing data. The sensor may sense at least one of temperature and humidity.

The apparatus may further include a memory for storing the compensation data. The memory may be one of a register, an SRAM, a DRAM, and a flash memory.

The relative position may be determined based on the test signal received at a first one of the speakers and played by the first speaker and the played test signal is received by the other speakers.

Advantageous embodiments of the invention are illustrated in the accompanying drawings and will be described below. In the drawings:
Figure 1 shows a block diagram of an audio playback system according to an embodiment of the present invention;
Figure 2 shows a block diagram of a controller in the audio playback system of Figure 1;
Figure 3 shows an audio playback system according to another embodiment of the present invention; and
Figure 4 shows still another embodiment of an audio playback system according to the present invention.

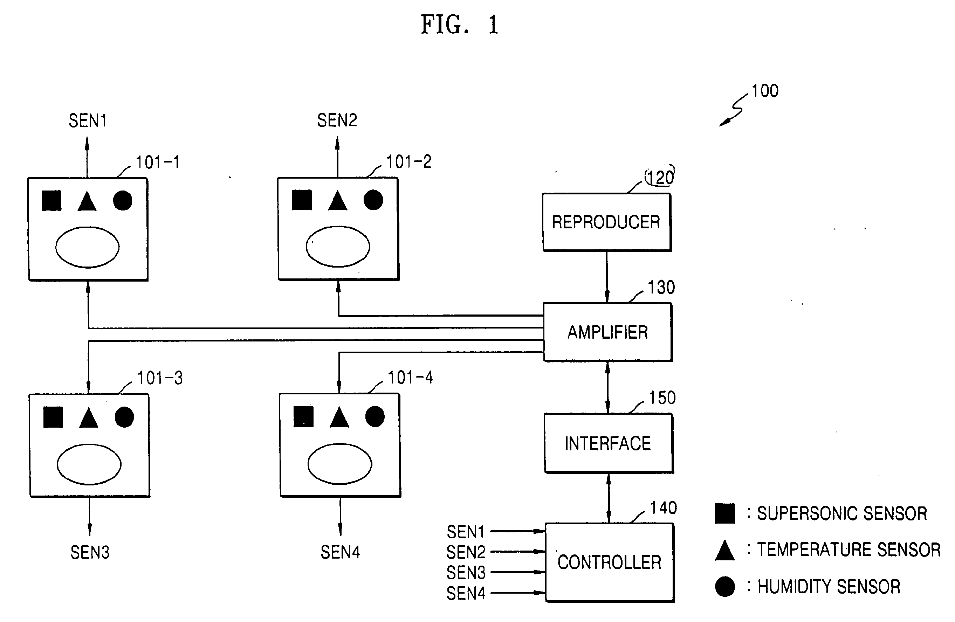

Referring to Figure 1, an audio playback system 100 includes a reproducer 120, controller 140, an amplifier 130, an interface 150, and a plurality of speakers 101-1-101-4. for receiving the amplified audio playback signals. The reproducer 120 is an audio playback medium such as a CD or a DVD player, or a signal received from a microphone (not shown). The audio signals from the reproducer 120 is amplified by amplifier 130 and forwarded to each of the speakers 101-1 to 101-4 for playback in the form of audible sound. Each of the speakers 101-1 to 101-4 includes environmental condition sensors for sensing environmental conditions such as temperature and humidity. The sensed environmental conditions from each speaker are reported as sensed data to controller 140, and the sensed data is analyzed by the controller 140 to determine if changes need to be made to the audio playback signal to compensate for the changed environmental conditions. According to this embodiment of the present invention, each of the speakers 101-1 to 101-4 includes a transceiver for transmitting and receiving signals. The sensed data is transmitted from the speakers to the controller 140 by the transceiver. Preferably, the transceiver is an ultrasonic transceiver which transmits and receives signals wirelessly. It is readily appreciated by one skilled in the art that data can be communicated to the controller 140 by other known means. One example is by wired connections.

According to a further embodiment of the present invention, the audio playback system 100 determines the relative distance of the speakers and the relative distance information is also used by the controller 140 to determine if changes need to be made to optimize playback.

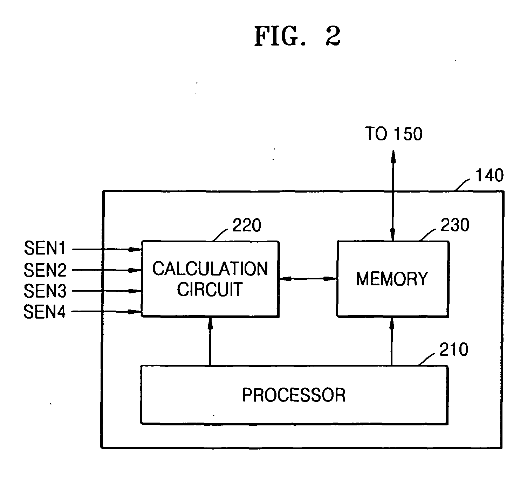

Figure 2 shows a block diagram of the controller 140. Controller 140 includes a processor 210, a calculation circuit 220 and an associated memory 230. Memory 230 preferably includes a read only memory (ROM) or flash memory, registers, or RAMS. The ROM or flash memory is used for storing program codes executable by a processor 210 for interfacing the audio playback system 100 including the amplifier 150 and other functions including calculating relative positions of the speakers based on position data and controlling the playback signals based on position data or sensed data received from the sensors of the speakers. The registers or RAMs store data such as sensed data and position data from the speakers. The RAMs can be DRAMs or SRAMs. The processor 210 is preferably a digital signal processor (DSP) capable of processing digitized audio signals as well as handling functions of a CPU. The calculation circuit 220 receives the position data and sensed data from the speakers.

To determine relative position of the speakers, a test signal is sent to the first speaker 101-1. This test signal is in turn sent by speaker 101-1 to the other speakers 101-2 to 101-4. From the time of return of the test signal transmitted to speaker 101-1 from speakers 101-2 to 4, relative distance of speakers 101-2 to 4 from speaker 101 can be determined. For example, if the return signal for speaker 101-3 takes longer than speakers 101-2 and 101-4, speaker 101-3 has the largest distance or is the furthest away from speaker 101-1. The return signals (or positional data) from speakers 101-2 to 4 are forwarded to the controller 140. A program module stored in memory 230 is executed by processor 210 to determine the relative distance between the speakers based on the positional data. From such determination, controller 140 can make adjustments to the actual audio playback signals to compensate for differences in placement of the speakers from optimal positions. For example, if it is determined that speaker 101-3 is further from the optimal distance, the playback signal designated for speaker 101-3 is adjusted temporarily or in frequency or tone with compensating effect for the further distance.

According to an alternative embodiment of the invention, instead of using an ultrasonic transceiver, the test signal is played over speaker 101-1 and the played testing signal is received by the speakers of each of speakers 101-2 to 4. According to this embodiment, the speaker element of each of speakers 101-2 to 4 acts as a microphone for receiving the test signal. Upon receipt of the test signal, each of speakers 101-2 to 4 reports to controller 140 that it has received the test signal through amplifier 130. The controller 140 determines the relative distance between speaker 101-1 to each of speakers 101-2 to 4 based on the signals received from speakers 101-2 to 4. It is apparent to one skilled in the art that an actual microphone can also be used in the receiving speakers as the detector for detecting the test signal.

Referring to Figures 1 and 2, the controller 140 makes adjustments to audio playback signal by generating compensation data based on the positional data or time of arrival signals received from speakers 101-2 to 4. The compensation data is transmitted to the amplifier for changing the volumn, delay, phase, etc. of the signal to be forwarded to the speakers. The compensation data can be stored in memory 230 or can be forwarded directly to the amplifier 130. Additionally, the environmental sensors disposed in each of speakers 101 periodically reports sensed data, such as temperature and humidity, to the controller 140. The sensed data is stored in memory 230 of controller 140 and upon detection of a change in environmental conditions of a preset amount, such as 5° Fahrenheit, the controller 140 adjusts the audio playback signal to compensate for the changed environmental condition. For example, a change in temperature of 5° Fahrenheit may require an adjustment of 0.5 seconds in time for the signal designated for the speaker with the changed environmental condition.

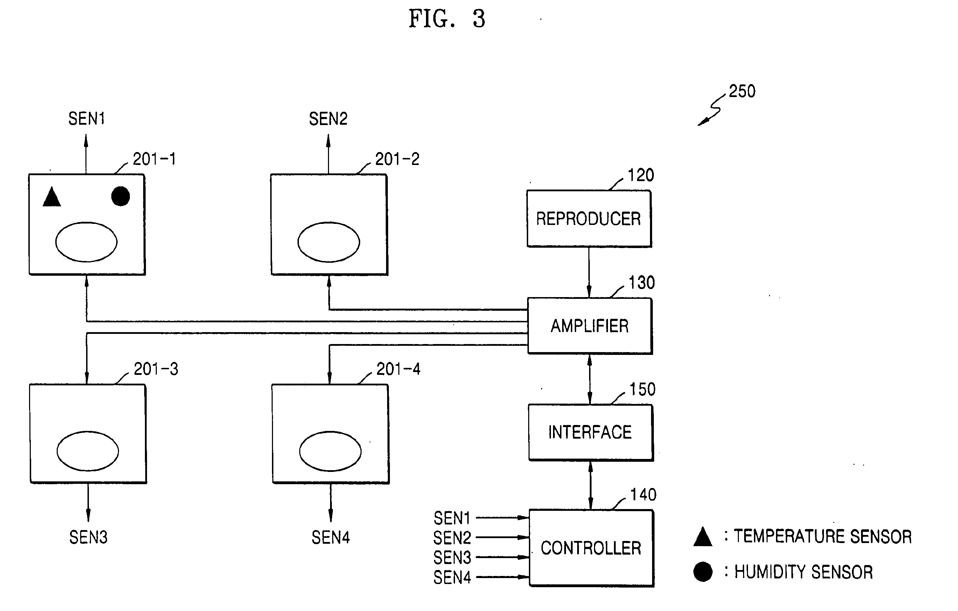

Figure 3 shows an alternative embodiment of an audio playback system of the present invention. According to this embodiment, instead of having environmental sensors in each of speakers 101-1 to 101-4, the environmental sensors are placed in only one of the speakers, for example at 201-1. The sensed signal is reported by the sensor(s) at speaker 201-1 to controller 140 and adjustments based on environmental conditions are made for all speakers 201-1 to 4. The audio playback system according to this embodiment is applicable to a system wherein speakers are placed in an area where the environmental conditions are essentially the same for all the speakers.

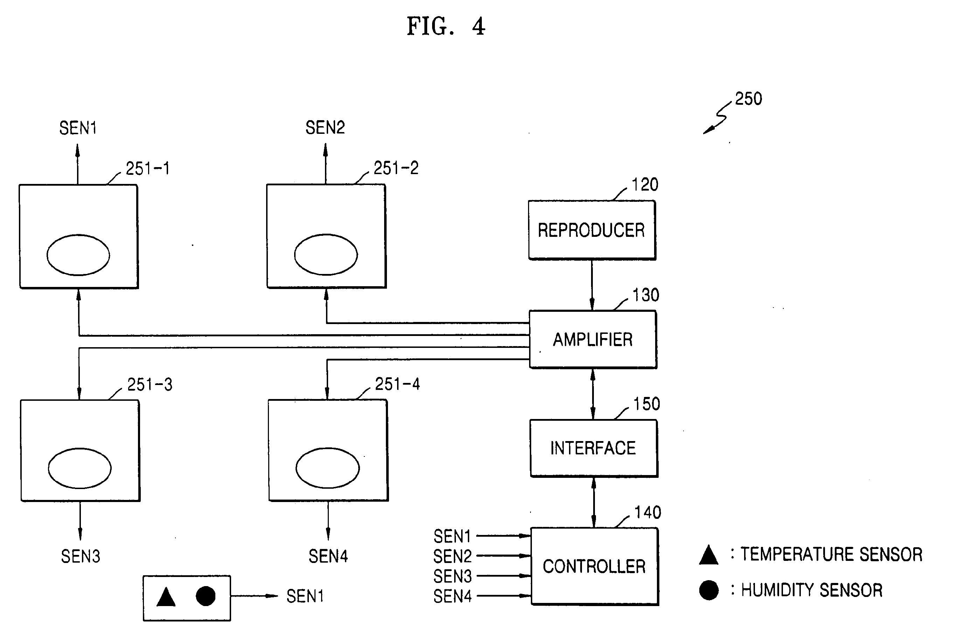

Figure 4 shows still another embodiment of the present invention. According to this embodiment, the environmental sensors are not disposed in any of the speakers 251-1 to 251-4, but is disposed proximal to the speakers. The environmental sensors may also be placed at controller 140. The controller 140 makes adjustments to the audio playback signal based on the changed environmental conditions sensed by the environmental sensors.

## Claims

1. An apparatus for controlling a plurality of speakers, comprising
- an amplifier (130) for amplifying a play signal to be played over the speakers (101-1,...,101-4);
**characterized by**
- at least one sensor disposed proximal to at least one of the speakers for sensing at least one environmental condition and outputting sensed data to a controller, wherein the controller adjusts the play signal to compensate for environmental changes based on the sensed data.

2. The apparatus of claim 1, further including a detector disposed in each of the speakers configured for receiving a test signal originating from the controller and for reporting to the controller the test signal received at respective speakers, wherein the controller determines the relative positions of the speakers based on the test signals reported by the speakers.

3. The apparatus of claim 2, wherein the controller generates compensation data for adjusting the play signal for respective speakers based on the relative positions of the speakers.

4. The apparatus of claim 2 or 3, wherein the reported signal is amplified by the amplifier prior to receipt by the controller.

5. An apparatus for controlling a plurality of speakers, comprising
- an amplifier (130) for amplifying and outputting a play signal to be played over the speakers (101-1,...,101-4);
**characterized by**
- a controller (140) for originating a test signal for receipt by the plurality of speakers and for receiving return signals from each speaker, the return signals representing signals as received at each respective speaker in response to the test signal from a first speaker, said controller for determining relative positions of the speakers based on the return signals and for generating compensation data based on the relative positions of the speakers, wherein the compensation data is used for adjusting the play signal.

6. The apparatus of claim 5, further including a detector disposed in each speaker for receiving the test signal.

7. The apparatus of claim 5 or 6, further including at least one sensor disposed proximal to at least one of the speakers for sensing at least one environmental condition and outputting sensing data to the controller, wherein the controller adjusts the play signal to compensate for environmental changes based on the sensing data.

8. The apparatus of any of claims 2 to 7, wherein the detector is an ultrasonic detector or a speaker used as a microphone or a microphone.

9. The apparatus of any of claims 1 to 4, 7 and 8, wherein the sensor senses at least one of temperature and humidity.

10. The apparatus of any of claims 3 to 9, further including a memory for storing the compensation data.

11. The apparatus of claim 10, wherein the memory further stores sensed data read at the time of determination of the relative positions of the speakers.

12. The apparatus of claim 10 or 11, wherein the memory is one of a register, an SRAM, a DRAM, and a flash memory.

13. The apparatus of any of claims 3 to 12, wherein the relative position is determined based on the test signal received at a first one of the speakers and played by the first speaker and the played test signal is received by the other speakers.

14. The apparatus of any of claims 1 to 4 and 7 to 13, wherein a respective one of the sensors is disposed in each of the speakers or the sensor is disposed in the controller.

15. A method of controlling a plurality of speakers, comprising:
outputting from an amplifier an amplified play signal to be played over the speakers;
sensing by a sensor at least one environmental condition at a position proximal to at least one of the speakers and outputting sensing data to a controller; and
adjusting the play signal to compensate for environmental changes based on the sensing data.

16. The method of claim 15, wherein the sensor senses at least one of temperature and humidity.

17. The method of claim 15 or 16, further including determining relative positions of the speakers by:
receiving at each speaker a test signal originating from the controller;
reporting to the controller the test signal received at respective speakers; and calculating relative positions of the speakers based on the test signals reported by the speakers.

18. The method of claim 17, further including generating compensation data for adjusting the play signal for respective speakers based on the relative positions of the speakers.

19. The method of claim 18, further including storing in a memory the compensation data and/or storing sensing data read at the time of determination of the relative positions of the speakers, preferably the memory being one of a register, an SRAM, a DRAM, and a flash memory.

20. The method of any of claims 17 to 19, wherein the step of receiving is performed by an ultrasonic detector or by a speaker used as a microphone or by a microphone.

21. The method of any of claims 17 to 20, wherein the step of reporting to the controller the test signal is by wireless transmission.

22. The method of any of claims 17 to 21, wherein the relative position is determined based on the test signal received at a first one of the speakers and played by the first speaker and the played test signal is received by the other speakers.

23. The method of any of claims 17 to 22, wherein a respective one of the sensors is disposed in each of the speakers or the at least one sensor is disposed in the controller, preferably the sensor sensing temperature and/or humidity.
